# EUROPEAN PATENT APPLICATION

(11) **EP 4 832 407 A1**
(43) Date of publication of application: **28.10.2026**
(21) Application number: 26173314.1
(22) Date of filing: 20.04.2026
(51) Int. Cl.: H04L 7/033, H03K 5/135, H03L 7/08, H03K 5/00

(54) **CLOCK DATA RECOVERY USING PHASE ERROR STATISTICS FOR I/Q CALIBRATION**

(30) Priority: 21.04.2025 US 202519184484
(71) Applicant: Avago Technologies International Sales Pte. Limited, Singapore 768923 (SG)
(72) Inventor: Singh, Ullas, Irvine, 92604 (US); Parthasarathy, Vasudevan, Irvine, 92620 (US); Fan, Qiang, Irvine, 92618 (US)
(74) Representative: Dilg, Haeusler, Schindelmann Patentanwaltsgesellschaft mbH

(57) **Abstract**

A clock recovery system includes a tuning circuit configured to receive an initial I-clock and an initial Q-clock and output an adjusted I-clock and an adjusted Q-clock. A phase interpolator is configured to receive the adjusted I-clock and the adjusted Q-clock and generate an interpolated clock. Control circuitry is configured to generate a tuning code for the tuning circuit based on a phase error metric derived from the interpolated clock. The tuning circuit may include an in-phase LC circuit to adjust the phase of the initial I-clock and a quadrature-phase LC circuit to adjust the phase of the initial Q-clock. The control circuitry may adjust capacitance of I-capacitor and Q-capacitor banks in the LC circuits based on the tuning code to optimize clock recovery performance.

## Description

### BACKGROUND

High-speed data communication systems rely on precise timing and synchronization between transmitters and receivers to accurately transmit and recover data. As data rates continue to increase, maintaining proper clock alignment and phase relationships becomes increasingly challenging.

Clock recovery and data sampling in receivers are critical functions that impact overall system performance. Receivers must be able to extract timing information from incoming signals and generate sampling clocks that are properly aligned to capture data with minimal errors. This often involves techniques like phase interpolation to finely adjust clock phases.

However, various factors can introduce timing mismatches and phase errors in clock distribution networks. As used herein, the term "phase misalignment" refers to a deviation from the intended phase relationship between two or more clock signals. Manufacturing variations, temperature fluctuations, and signal propagation effects can all contribute to phase misalignment between clock signals. Even small timing skews between in-phase and quadrature clock components can degrade signal integrity and increase bit error rates.

Additionally, as transmission channels become more complex and lossy at higher frequencies, receivers must compensate for signal distortions like intersymbol interference. This requires sophisticated equalization and timing recovery techniques to maintain synchronization with incoming data streams.

Analog-to-digital converters (ADCs) play an important role in modern receiver architectures by digitizing incoming analog signals. The sampling instants of ADCs must be precisely controlled to capture optimal data points. Phase interpolators are often used to generate finely adjustable sampling clocks for ADCs.

Overall, high-speed communication systems face ongoing challenges in clock generation, distribution, and recovery. Maintaining proper timing relationships throughout receiver subsystems is crucial for achieving low bit error rates and robust performance. Continued innovations are needed to address timing impairments and enable ever-higher data rates.

### BRIEF DESCRIPTION OF DRAWINGS

The accompanying drawings, which form part of this specification, depict examples of the disclosure and, along with the description, illustrate the underlying principles of these examples. The detailed description is provided with reference to the accompanying figures. In the figures, the leading digit(s) of each reference number correspond to the figure where the reference number first appears. The figures are not drawn to scale, and certain proportions or elements may be exaggerated in some figures to enhance the clarity of specific features.

Non-limiting and non-exhaustive examples are described with reference to the following figures.
FIG. 1 illustrates an exemplary clock recovery system 100, in accordance with one or more embodiments of the disclosure.
FIG. 2 illustrates an exemplary tuning circuit, in accordance with one or more embodiments of the disclosure.
FIG. 3 depicts exemplary graphs showing phase error metrics and bit error rate measurements for different center frequencies, in accordance with one or more embodiments of the disclosure.

In the drawings, like reference symbols and numerals indicate the same or similar components. Like elements in the various figures are denoted by like reference symbols and numerals for consistency. Identical or similar items across different figures are indicated by the same reference numbers. Unless otherwise indicated, like elements and method steps are referred to with like reference numerals.

### DETAILED DESCRIPTION OF THE INVENTION

The following describes technical solutions in this specification with reference to the accompanying drawings. It should be recognized, however, that such description is not intended as a limitation on the scope of the present disclosure. Rather, the description also encompasses combinations and modifications to those exemplary aspects described herein. Exemplary embodiments are described in detail with reference to the accompanying drawings.

The present disclosure relates to systems and methods for clock data recovery (CDR) and calibration of in-phase and quadrature (I/Q) clock mismatch in high-speed communication receivers. In some cases, CDR techniques may be used to extract timing information from received data signals in order to properly sample and recover transmitted data. Clock mismatch between an I-clock and a Q-clock used for sampling may introduce errors and degrade receiver performance.

The disclosed techniques utilize phase error statistics obtained from CDR operations to calibrate I/Q clock mismatch. In some cases, the calibration may be performed in a blind manner without requiring specific training sequences. The calibration approach may be protocol and data rate independent, allowing it to be applied across different communication standards and data rates.

By analyzing statistical properties of CDR phase errors, information about clock mismatch may be inferred and used to adjust clock generation circuitry. This may allow clock mismatch to be reduced without requiring dedicated calibration hardware. In some cases, the calibration may be performed using existing CDR and digital signal processing (DSP) components already present in the receiver.

The disclosed techniques may provide improvements in bit error rate performance by reducing sampling errors caused by I/Q clock mismatch. Additionally, the calibration may be performed with minimal power and area overhead by leveraging existing receiver components. The approach may be applicable to various types of communication media including optical, electrical, and wireless systems.

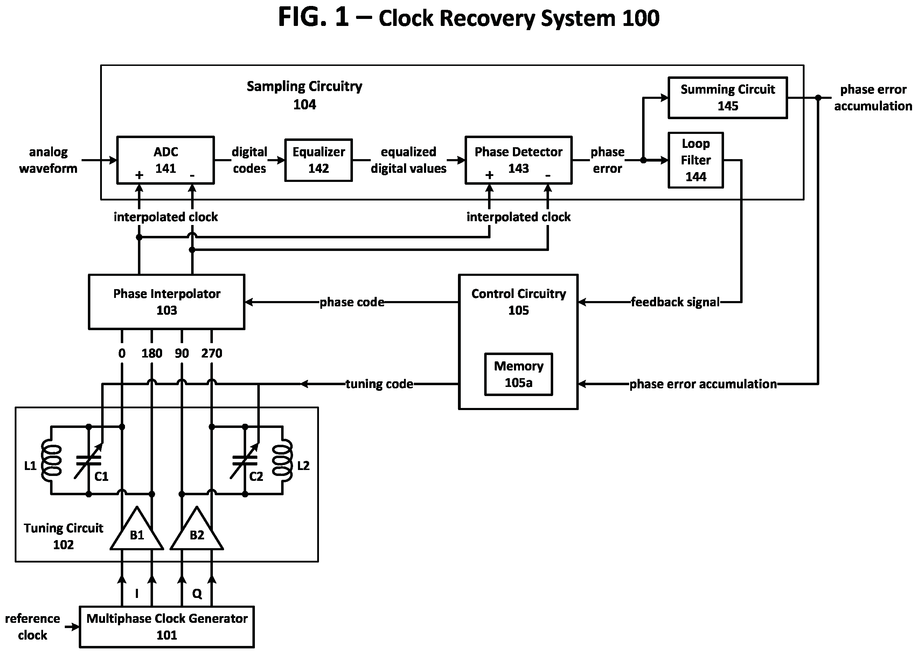

FIG. 1 illustrates an exemplary clock recovery system 100. The clock recovery system 100 may be an apparatus. The clock recovery system 100 may include a multiphase clock generator 101, a tuning circuit 102, a phase interpolator 103, sampling circuitry 104 and control circuitry 105. Those skilled in the art will appreciate that there may be additional components in the clock recovery system 100 that are not shown in FIG. 1.

The multiphase clock generator 101 is electronic circuitry that may generate multiple phase-shifted clocks from a stable and precise reference clock. Referred to herein, the reference clock may be any periodic waveform. A periodic waveform is a signal that repeats itself at regular intervals over time. Specifically, each cycle of the periodic waveform is a complete repetition of the signal that takes the same amount of time. Those skilled in the art will appreciate that reference clock may exist in the form of a rectangular wave, a sine wave, a triangle wave, a sawtooth wave and/or any other periodic waveform.

As used herein, the term "clock phase" refers to a specific timing point within the periodic waveform of a clock signal. A clock phase represents a particular instant in the cyclical progression of the clock signal, typically measured in degrees from 0° to 360°.

The multiple phase-shifted clocks are labeled in FIG. 1 as I-clock ("I" stands for in-phase) and Q-clock ("Q" stands for quadrature-phase). As used herein, a "global clock distribution network" refers to the network of interconnects and buffers used to route an initial I-clock and an initial Q-clock generated by the multiphase clock generator 101 to various points across an integrated circuit chip.

In some instances, the global clock distribution network can introduce phase misalignment between clock phases of the initial I-clock and the initial Q-clock. This phase misalignment may arise from various factors such as manufacturing variations, temperature fluctuations, non-uniform signal propagation and/or other factors. Phase misalignment may lead to non-ideal sampling of the incoming analog waveform, potentially increasing a bit error rate in the clock recovery system 100. In some instances, phase misalignment may cause timing skew between phases of the initial I-clock and the initial Q-clock. As used herein, the term "timing skew" refers to unwanted deviations in the relative timing between the initial I-clock and the initial Q-clock from their ideal phase relationships, often introduced by variations in signal path lengths, component mismatches, and/or other non-idealities.

In the context of multiple clock phases, I-phase (in-phase) and Q-phase (quadrature-phase) refer to the initial I-clock and the initial Q-clock that are offset by 90 degrees in phase. The I/Q terminology, originating from analog and RF systems, has been adopted in digital clocking to characterize orthogonal timing relationships between the initial I-clock and the initial Q-clock, facilitating effective data sampling, multiplexing, and modulation.

The I-phase is aligned with the 0° phase of the clock cycle, while the Q-phase is shifted by 90°, placing it a quarter of a cycle ahead. In a four-phase clock system - typically consisting of 0°, 90°, 180°, and 270° phases - these labels help describe relative phase relationships between an adjusted I-clock and an adjusted Q-clock. As used herein, the term "phase relationship" refers to the temporal relationship between the initial I-clock and the initial Q-clock such as the phase differences or time delays between the initial I-clock and the initial Q-clock.

This evenly spaced phase distribution divides the clock period into four equal segments, which is particularly advantageous for systems requiring precise timing and synchronization, such as the sampling circuitry 104. By generating these multiple phases, the multiphase clock generator 101 may enable fine-grained control over timing in an interpolated clock, allowing for precise alignment of the interpolated clock with an incoming analog waveform.

The 180° phase is the inverted I-phase (-I), and the 270° phase is the inverted Q-phase (-Q). In the example of FIG. 1, the multiple clock phases (e.g., 0°, 90°, 180°, 270°) are evenly spaced in phase over one clock period. These evenly spaced clock phases provide precise timing references. For instance, the 0° phase may represent an edge of the reference clock, while the 90°, 180°, and 270° phases may correspond to subsequent quarter-cycle intervals of the reference clock.

The concept of I and Q phases can also be extended to multi-level signaling schemes, where additional phase relationships (e.g., 45°, 135°) may be introduced to support higher-order modulation formats. In octal-phase systems, for example, generating clock phases at 45° intervals (0°, 45°, 90°, 135°, 180°, 225°, 270°, 315°) enables support for higher-order modulation formats or more precise timing control. Those skilled in the art will recognize many modifications may be made to this configuration without departing from the scope or spirit of the multi-clock phase systems described herein.

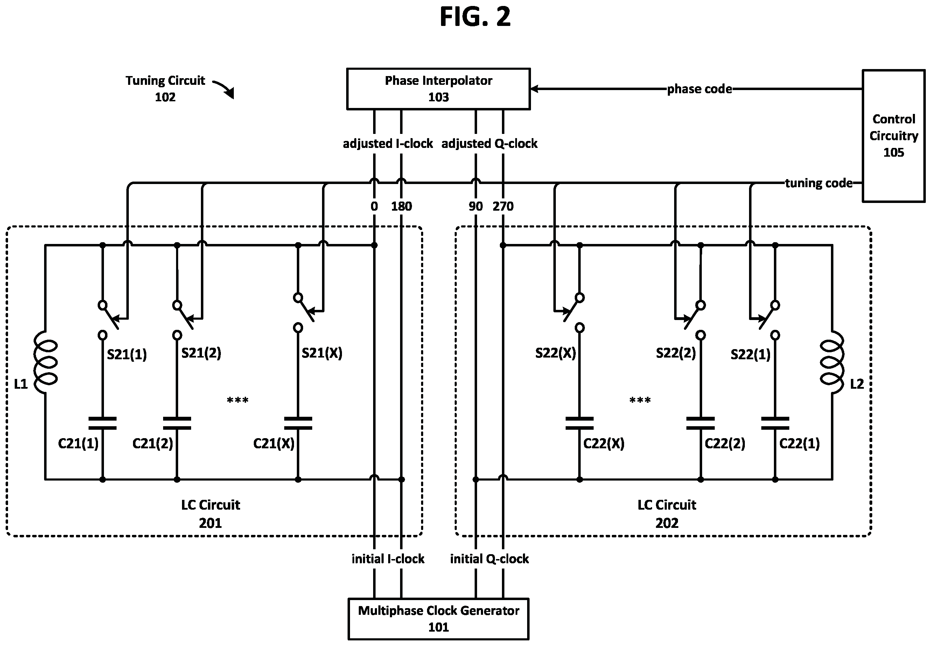

Illustrated in FIG. 2 are the initial I-clock and the initial Q-clock. The multiphase clock generator 101 may generate the initial I-clock and the initial Q-clock. The tuning circuit 102 may receive the initial I-clock and the initial Q-clock from the multiphase clock generator 101.

The tuning circuit 102 is an electronic circuitry designed to adjust the phase relationship between the initial I-clock and the initial Q-clock. The tuning circuit 102 comprises several key components designed to adjust and optimize the phase relationships between the initial I-clock and the initial Q-clock. For the in-phase signal path, these components include the in-phase buffer B1, the in-phase capacitor bank C1 and the in-phase inductor L1. For the quadrature-phase signal path, these components include the quadrature-phase buffer B2, the quadrature-phase capacitor bank C2, and the quadrature-phase inductor L2. The in-phase capacitor bank C1 and the quadrature-phase capacitor bank C2 are adjustable capacitive elements. The in-phase buffer B1 and quadrature-phase buffer B2 may working in tandem with the other tuning circuit 102 components to maintain proper quadrature phase relationships between the initial I-clock and the initial Q-clock. Those skilled in the art will appreciate that there may be additional components in the tuning circuit 102 that are not shown in FIG. 1.

Referring to FIG. 2, tuning circuit 102 may include an in-phase LC circuit 201 and a quadrature-phase LC circuit 202. In-phase LC circuit 201 and quadrature-phase LC circuit 202 are both implemented as an LC tank circuit. For instance, the in-phase LC circuit 201 may include in-phase inductor L1. Having in-phase switches S21(1) - S21(X) and in-phase capacitors C21(1) - C21(X), an in-phase capacitor bank C1 in the in-phase LC circuit 201 may happen to be the in-phase capacitor bank C1 of FIG. 1. In-phase switch S21(1) corresponds with in-phase capacitor C21(1), in-phase switch S21(2) corresponds with in-phase capacitor C21(2), and in-phase switch S21(X) corresponds with in-phase capacitor C21(X) in FIG. 2 by way of illustration. Any one of the in-phase capacitors C21(1) - C21(X) could be individually referred to as "in-phase capacitor C21." Any one of the in-phase switches S21(1) - S21(X) could be individually referred to as "in-phase switch S21." The in-phase switch S21 is in series with in-phase capacitor C21. In some configurations, a capacitance for one of the in-phase capacitors C21(1) - C21(X) may differ from a capacitance for another of the in-phase capacitors C21(1) - C21(X). In other configurations, each of the in-phase capacitors C21(1) - C21(X) could be of the same capacitance.

The quadrature-phase LC circuit 202 may include quadrature-phase inductor L2. Having quadrature-phase switches S22(1) - S22(X) and quadrature-phase capacitors C22(1) - C22(X), a quadrature-phase capacitor bank C2 in the quadrature-phase LC circuit 202 may happen to be the quadrature-phase capacitor bank C2 of FIG. 1. Quadrature-phase switch S22(1) corresponds with quadrature-phase capacitor C22(1), quadrature-phase switch S22(2) corresponds with quadrature-phase capacitor C22(2), and quadrature-phase switch S22(X) corresponds with quadrature-phase capacitor C22(X) in FIG. 2 by way of illustration. Any one of the quadrature-phase capacitors C22(1) - C22(X) could be individually referred to as "quadrature-phase capacitor C22." Any one of the quadrature-phase switches S22(1) - S22(X) could be individually referred to as "quadrature-phase switch S22." Quadrature-phase switch S22 is in series with quadrature-phase capacitor C22. In some implementations, a capacitance for one of the quadrature-phase capacitors C22(1) - C22(X) may differ from a capacitance for another of the quadrature-phase capacitors C22(1) - C22(X). In other implementations, each of the quadrature-phase capacitors C22(1) - C22(X) could be of the same capacitance. Regarding the in-phase LC circuit 201 and quadrature-phase LC circuit 202, the number "X" is an integer greater than 1.

Illustrated in FIG. 2 are the adjusted I-clock and the adjusted Q-clock. The tuning circuit 102 may output the adjusted I-clock and the adjusted Q-clock to the phase interpolator 103.

The phase interpolator 103 is electronic circuitry that is responsible for generating finely-tuned clock phases by interpolating between multiple input clock phases. As used herein, the term "phase interpolator 103" refers to a circuit that generates the interpolated clock by interpolating between multiple evenly phase-shifted clock inputs, typically at 0°, 90°, 180°, and 270°. The phase interpolator 103 may receive the adjusted I-clock (e.g., 0° and 180°) and the adjusted Q-clock (e.g., 90° and 270°) from the tuning circuit 102 and produce an interpolated clock with a phase that is continuously tunable across 360°. Under such circumstances, the phase interpolator 103 may provide full 360° phase control in fine steps.

For instance, the phase interpolator 103 may receive the adjusted I-clock and the adjusted Q-clock from tuning circuit 102 and produce the interpolated clock with a phase that can be precisely controlled. As used herein, the term "phase interpolation" refers to the process of generating intermediate phases between two or more phases of the initial I-clock and the initial Q-clock. The phase interpolator 103 may perform phase interpolation by blending or weighting the I and Q clocks using analog or digital techniques, such as current steering or multiplexer logic. Interpolating the I-clock and the Q-clock is a process of performing the phase interpolation to produce an interpolated clock with a phase that lies between the I-clock and the Q-clock. The phase interpolator 103 may perform the phase interpolation by interpolating the initial I-clock and the initial Q-clock. The interpolated clock has a controllable output phase that is adjustable by phase interpolator 103 between the phases of the I and Q clocks.

The phase interpolator 103 may interpolate, in response to the tuning circuit 102 reducing the phase misalignment between the I-clock and the Q-clock, the I-clock and the Q-clock to produce an interpolated clock. The phase interpolator 103 may generate an intermediate phase between the adjusted I-clock and the adjusted Q-clock. The tuning circuit 102 may provide a more accurate starting point for interpolation by reducing phase misalignment between the adjusted I-clock and the adjusted Q-clock. The phase interpolator 103 may generate the interpolated clock that more closely aligns with the optimal sampling points of the incoming analog waveform. The improved alignment may enhance the overall timing recovery performance of the clock recovery system 100. The clock recovery system 100 may achieve lower bit error rates and more reliable data sampling by the ADC 141 due to the improved alignment.

In some instances, the interpolated clock may happen to be a differential signal having an improved noise immunity and lower electromagnetic interference (EMI) than a single-ended clock. The differential interpolated clock from the phase interpolator 103 may be required in many high-speed I/O standards such as Peripheral Component Interconnect Express (PCIe), Serial Advanced Technology Attachment (SATA), Ethernet and/or other standards. In other instances, the interpolated clock may be a single-ended clock.

As used herein, the term "interpolation resolution" refers to the smallest phase step that can be reliably produced by the phase interpolator 103. The interpolation resolution depends on the precision of the weighting mechanism within the phase interpolator 103 and the quality of the input clock phases. Interpolation resolution is typically expressed as a fraction of the input clock period or in degrees of phase. For example, the phase interpolator 103 may achieve an interpolation resolution of 1 degree or better, enabling precise positioning of an edge of the interpolated clock.

Higher interpolation resolution allows for more precise alignment of the interpolated clock with the incoming analog waveform, potentially improving the overall performance of the clock recovery system 100.

The phase interpolator 103 may process the adjusted I-clock and the adjusted Q-clock to produce a precisely-controlled interpolated clock. For instance, the phase interpolator 103 may perform fractional phase interpolation by combining adjacent phases of the adjusted I-clock and the adjusted Q-clock with variable weighting to generate intermediate phases of the adjusted I-clock and the adjusted Q-clock with sub-degree resolution, allowing for extremely fine-grained timing adjustments.

As used herein, the term "fractional phase interpolation" refers to a technique used in the phase interpolator 103 to generate clock phases of the adjusted I-clock and the adjusted Q-clock that fall between the discrete clock phases of the adjusted I-clock and the adjusted Q-clock provided by the multiphase clock generator 101. Fractional phase interpolation typically involves weighted mixing or combining of adjacent clock phases of the adjusted I-clock and the adjusted Q-clock to produce a continuous range of output phases for the adjusted I-clock and the adjusted Q-clock, enabling precise alignment of the interpolated clock with the incoming analog waveform in the clock recovery system 100. The weighting factors are controlled by a phase code from the control circuitry 105, allowing for fine-grained phase adjustment of the interpolated clock.

Fractional phase interpolation allows for finer granularity in phase adjustment of the interpolated clock than would be possible using only the input clock phases of the adjusted I-clock and the adjusted Q-clock. For instance, when receiving the adjusted I-clock and the adjusted Q-clock, the phase interpolator 103 may apply one or more weighted mixing techniques to create a continuous spectrum of output phases between the adjusted I-clock and the adjusted Q-clock from the tuning circuit 102. These techniques may involve combining the adjusted I-clock and the adjusted Q-clock with variable weighting factors to produce a continuous range of phases for the interpolated clock. Phase interpolation typically involves weighted mixing or combining of the adjusted I-clock and the adjusted Q-clock to produce the continuous range of phases. To generate the phase for the interpolated clock, the phase interpolator 103 receives the adjusted I-clock and the adjusted Q-clock from the tuning circuit 102 then applies precise weighting factors to the adjusted I-clock and the adjusted Q-clock.

The phase interpolator 103 may dynamically adjust the contribution of each input phase to create the desired output frequency for the interpolated clock. For instance, the phase interpolator 103 may generate the interpolated clock at a frequency that is a non-integer multiples of the adjusted I-clock and the adjusted Q-clock. This capability enables the clock recovery system 100 to synchronize with the incoming analog waveform that may happen to be at frequencies unrelated to the frequency of the adjusted I-clock and the adjusted Q-clock.

The sampling circuitry 104 includes an analog-to-digital converter (ADC) 141, an equalizer circuit 142, a phase detector 143, a loop filter 144, and a summing circuit 145. This integrated sampling and processing system enables the clock recovery system 100 to accurately recover timing information from the incoming analog waveform and maintain synchronization. Those skilled in the art will appreciate that there may be additional components in the sampling circuitry 104 that are not shown in FIG. 1.

The ADC 141 is an electronic circuit that samples an incoming analog waveform at discrete time intervals to convert the incoming analog waveform into a sequence of digital values. The sequence is a digital representation of the incoming analog waveform. As used herein, the term "incoming analog waveform" refers to the continuous-time, continuous-amplitude signal received by the ADC 141. This incoming analog waveform may represent data transmitted over a communication transmission channel and may contain information encoded in its amplitude, frequency, or phase variations over time.

The sequence of digital values represents the discrete amplitude levels of incoming analog waveform measured by the ADC 141 at the time intervals. Each digital value represents an amplitude level of the incoming analog waveform at a respective sampling point. The ADC 141 may quantize each amplitude level of the incoming analog waveform into a finite number of digital levels.

Typically expressed in bits (e.g., 4-bit, 9-bit, 16-bit, etc.), the term "resolution" referred to herein is the number of digital levels that the ADC 141 may use to represent each amplitude level of the incoming analog waveform. In such instances, the resolution may be from 7 to 12 bits per sample at 50 giga samples per second. A higher resolution may provide finer granularity and greater precision in representing an amplitude level of the incoming analog waveform. For example, as a 5-bit converter, the ADC 141 may have 32 possible levels of resolution. By comparison, the ADC 141 as an 8-bit converter may have 256 possible levels of resolution, allowing for more detailed digital representation of the incoming analog waveform. The resolution examples are given merely for illustration and are not intended to limit the resolution of the ADC 141. Instead, the resolution of the ADC 141 may be any predetermined resolution.

The ADC 141 may receive and convert the incoming analog waveform into digital codes representing the signal amplitude of the incoming analog waveform. For instance, the ADC 141 may sample the incoming analog waveform by measuring discrete amplitude levels of the incoming analog waveform at discrete sampling points. Referred to herein, a "sampling point" is the precise moment in time at which the ADC 141 measures the discrete amplitude levels of the incoming analog waveform. Sampling points may occur at regular time intervals defined by the sampling rate.

Referred to herein, the "sampling rate" is the frequency at which the ADC 141 measures discrete amplitude levels of the incoming analog waveform. The sampling rate, typically measured in samples per second (Hertz), dictates how frequently the ADC 141 may measure the incoming analog waveform. For example, a 1 kHz sampling rate would mean that the ADC 141 takes 1,000 samples of the incoming analog waveform per second. In other examples, a capture may be on the order of 1 megabits of data. The ADC 141 may adhere to the Nyquist criterion, which requires the sampling rate to be at least twice the maximum frequency of the incoming analog waveform to avoid aliasing.

To optimize sampling, the ADC 141 may receive an interpolated clock from the phase interpolator 103. This interpolated clock may enable the ADC 141 to dynamically adjust sampling points for precise alignment with the incoming analog waveform phase. Specifically, the interpolated clock may designate sampling points that align closely with key characteristics of the incoming analog waveform such as peaks, troughs, zero-crossings, or other distinguishing features. In such cases, the interpolated clock may allow the ADC 141 to align sampling edges to the center of the eye diagram of the incoming analog waveform, ensuring accurate timing of sampling points.

Alignment of sampling edges to the center of the eye diagram may help compensate for skew and jitter in the incoming analog waveform. The ADC 141 may select the specific sampling points designated by the interpolated clock to achieve this optimal alignment. By processing the interpolated clock, the ADC 141 may adjust the phase of sampling intervals to occur at optimal points on the incoming analog waveform.

The ADC 141 may quantize the sampled values of the incoming analog waveform into digital codes representing the signal amplitude of the incoming analog waveform. As used herein, the term "sampled values" refers to discrete measurements of an incoming analog waveform's amplitude taken at specific time intervals by the ADC 141. The sampled values represent instantaneous snapshots of the continuous incoming analog waveform, captured at a sampling rate. As used herein, the term "quantization" refers to the process of mapping the sampled values of the incoming analog waveform to a finite set of discrete levels, represented by digital codes.

The equalizer circuit 142 may process the digital codes from the ADC 141. While processing the digital codes from the ADC 141, the equalizer circuit 142 may compensate for frequency-dependent attenuation and phase distortion in the incoming analog waveform introduced by a transmission channel. As used herein, the term "transmission channel" refers to the physical medium or path through which the incoming analog waveform propagates from a transmitter to a receiver in the communication system. In the context of this the clock recovery system 100, the transmission channel may encompass the signal path from a data source to the input of the ADC 141 including, but not limited to, printed circuit board traces, connectors, cables, and any intervening circuitry. The transmission channel may introduce various forms of signal degradation, such as attenuation, dispersion, reflections, and noise, which the equalizer circuit 142 aims to compensate for to improve signal quality and enable accurate data recovery.

The equalizer circuit 142 may compensate for transmission channel distortion in the incoming analog waveform by applying adaptive filtering techniques to counteract the effects of intersymbol interference, frequency-dependent loss, and other signal impairments. As used herein, the term "intersymbol interference" refers to the phenomenon where adjacent symbols in a digital transmission interfere with each other due to the limited bandwidth of the transmission channel, causing signal distortion and potentially leading to increased bit error rates (BER). The equalizer circuit 142 may adapt to changing transmission channel conditions to maintain optimal performance of the clock recovery system 100. This adaptive behavior may involve continuous monitoring of the transmission channel characteristics and automatic adjustment of equalizer parameters such as filter coefficients, tap weights, or decision thresholds to optimize signal quality under varying operating conditions.

As used herein, the term "transmission channel distortion" refers to the cumulative degradation of signal quality caused by various physical phenomena in the transmission channel, including frequency-dependent attenuation, phase shifts, reflections, and crosstalk.

While converting the digital codes into a set of equalized digital values, the equalizer circuit 142 may apply filtering techniques to mitigate intersymbol interference and improve signal quality before passing the set of equalized digital values to the phase detector 143. These filtering techniques may include, but are not limited to, feed-forward equalization (FFE), decision feedback equalization (DFE), or a combination of both, depending on the specific requirements of the clock recovery system 100.

The phase detector 143 is an electronic circuit that compares the timing of the interpolated clock with the timing of transitions in the set of equalized digital values and generates phase error signal. The phase error signal may take the form of an analog voltage or current, or a digital signal.

The phase error signal indicates the relative phase difference between the interpolated clock and the optimal sampling points of the incoming analog waveform. For instance, the phase error signal indicates whether the interpolated clock is early or late relative to the optimal sampling points of the incoming analog waveform. This early/late information drives the subsequent stages of the clock recovery loop, enabling the clock recovery system 100 to dynamically adjust the interpolated clock phase to track any variation of the data timing in the incoming analog waveform. The phase error signal generated by the phase detector 143 passes to the loop filter 144.

The loop filter 144 is an electronic circuit designed to process the phase error signal and generate a feedback signal for precise clock recovery. To refine and stabilize the phase error signal produced by the phase detector 143, the loop filter 144 may employ several operations.

Firstly, the loop filter 144 may apply low-pass filtering to the phase error signal. As used herein, the term "low-pass filtering" refers to a signal processing technique that attenuates high-frequency components of a signal while allowing lower-frequency components to pass through relatively unchanged. In the context of the loop filter 144, this filtering operation may serve to reduce high-frequency noise that may be present in the phase error signal, while preserving the lower-frequency components that typically represent genuine phase variations in the incoming analog waveform. This filtering operation may enhance the signal-to-noise ratio of the phase error signal, resulting in cleaner and more reliable feedback signal for subsequent processing stages.

Additionally, the loop filter 144 may perform temporal averaging or integration of the phase error signal. As used herein, the term "temporal averaging" refers to the process of combining the phase error signal over a specified time interval to produce a single, stable representation of the phase relationship between the interpolated clock and the incoming analog waveform. This averaging process may help to smooth out rapid fluctuations and transients in the phase error signal, which may be caused by noise or short-term instabilities in the clock recovery system 100. By averaging the phase error signal over time, the loop filter 144 may generate a more reliable feedback signal for adjusting the phase of the interpolated clock, reducing the likelihood of erroneous clock adjustments based on momentary phase fluctuations.

The combination of low-pass filtering and temporal averaging in the loop filter 144 may result in a refined feedback signal that more accurately reflects the true phase relationship between the interpolated clock and the incoming analog waveform. This feedback signal may enable the clock recovery system 100 to maintain precise timing alignment, even in the presence of noise and other signal impairments, thereby improving the overall performance and reliability of the data recovery process.

As used herein, the term "timing alignment" refers to the process of synchronizing the interpolated clock with the optimal sampling points of an incoming analog waveform. Timing alignment involves adjusting the phase relationship between the interpolated clock and the data transitions in the incoming analog waveform to ensure that sampling occurs at the ideal points for accurate data recovery. This alignment is critical for minimizing bit errors and optimizing the performance of the clock recovery system 100. Timing alignment is achieved through the dynamic adjustment of clock phases using a combination of the tuning circuit 102 and the phase interpolator 103.

As used herein, the term "optimal sampling points" refers to the specific instants in time within a data symbol period where the probability of correctly interpreting the transmitted data is maximized. These points typically correspond to the center of the data eye diagram, where the signal-to-noise ratio is highest and the effects of intersymbol interference are minimized. The clock recovery system 100 may continuously adjust the interpolated clock to align with these optimal sampling points to ensure reliable data recovery across varying channel conditions and data rates.

The summing circuit 145 is an electronic circuit that may produce a phase error accumulation signal by statistically analyzing multiple individual phase error signals from the phase detector 143 over a specified time interval or number of samples.

To produce the phase error accumulation signal, the summing circuit 145 may perform phase error accumulation. Phase error accumulation may refer to the process of aggregating individual phase error signals from the phase detector 143 over multiple clock cycles or data samples to produce a more stable and noise-resistant representation of the timing relationship between the interpolated clock and the incoming analog waveform. Phase error aggregation may refer to the process performed by the summing circuit 145 to combine the multiple individual phase error signals into the phase error accumulation signal. This aggregation may involve techniques such as arithmetic averaging, weighted summation, or more complex statistical methods to synthesize phase error information from the multiple individual phase error signals into a unified representation of phase misalignment.

The control circuitry 105 may receive the feedback signal from the loop filter 144 and the phase error accumulation signal from the summing circuit 145. Information that the control circuitry 105 extracts from the feedback signal and the phase error accumulation signal may enable the control circuitry 105 to detect and correct for phase drifts or systematic offsets that might not be apparent from an instantaneous phase error signal alone.

The control circuitry 105 is electronic hardware implemented as any suitable processing circuitry. The processing circuitry may include, but not limited to, at least one of a microcontroller, a microprocessor, a single processor, and a multiprocessor. The control circuitry 105 may include at least one of an embedded controller (EC), a central processing unit (CPU), an accelerated processing unit (APU), an application specific integrated circuit (ASIC), field programmable gate arrays (FPGA), control logic, a state machine, programmable processor, or the like. The control circuitry 105 may be implemented as electronic hardware that may include digital circuits, analog circuits or a combination of both digital and analog circuits. Analog circuits may include analog components that are suitable to process analog gate signals. Digital circuits may include switches and gates that are suitable to process digital gate signals. As will be explained in detail, the control circuitry 105 may control the functions and circuitry of the clock recovery system 100.

Memory 105a may be a non-transitory machine-readable storage medium. The non-transitory machine-readable storage medium may be a non-transitory processor readable or computer readable storage medium. The non-transitory machine-readable storage medium may comprise read-only memory ("ROM"), random access memory ("RAM"), other non-transitory computer-readable media and/or a combination thereof. Memory 105a may be any electronic, magnetic, optical, or other physical storage device. Memory 105a may store executable instructions for the control circuitry 105. In some examples, the executable instructions may be in the form of software and/or firmware. The software for the control circuitry 105 may include program code. The program code may include program instructions that are readable and executable by the control circuitry 105, also referred to as machine-readable instructions. Memory 105a may also store data, filters, rules and/or a combination thereof.

The control circuitry 105 may derive a phase error metric from the phase error accumulation signal, offering valuable insights into synchronization performance of the clock recovery process. The phase error metric provides an aggregate indication of timing synchronization performance that can be used to optimize clock recovery and sampling processes.

As used herein, the term "phase error metric" refers to a quantitative measure derived from the phase error accumulated signal that represents the degree of phase misalignment between the interpolated clock and the incoming analog waveform. Specifically, the phase error metric may represent an aggregate measure of phase misalignment between the interpolated clock and the incoming analog waveform. In some instances, the phase error metric is proportional to the phase difference between the interpolated clock and the incoming analog waveform. The phase error metric may represent the degree and direction of phase misalignment between of the adjusted I-clock and the adjusted Q-clock.

The phase error metric may include statistical representations of the phase error distribution that may take various forms. By way of example, the phase error metric may include variance of phase error, which may represent the square of the standard deviation, providing a measure of how far phase error values deviate from the mean. The phase error metric may include phase error probability distribution parameters, which may characterize the likelihood of different phase error magnitudes occurring, such as the mean and standard deviation of a Gaussian distribution fit to the phase error data. The phase error metric may include mean absolute error, which may represent the average of absolute values of individual phase errors, offering a straightforward measure of overall misalignment magnitude.

The phase error metric may include root mean square error (RMSE), which the control circuitry 105 may calculate by taking the square root of the average of squared phase errors, emphasizing larger deviations. The phase error metric may include peak phase error, which may represent the maximum absolute phase error observed over a specified time interval or number of samples, indicating worst-case misalignment. The phase error metric may include cumulative phase error, which may represent the sum of phase errors over time, potentially revealing systematic biases or drifts in clock alignment. The phase error metric may include phase error histogram statistics, which may derive from the distribution of phase errors, such as skewness or kurtosis, providing insights into the shape and characteristics of the error distribution.

The control circuitry 105 may derive a phase error metric from the phase error accumulation signal, which may provide an aggregate measure of timing synchronization performance in the clock recovery system 100. The control circuitry 105 may use a phase error metric as key performance indicator for dynamically adjusting a tuning code to minimize phase misalignment and improve data recovery accuracy in the clock recovery system 100. For instance, the control circuit 105 may convert the phase error metric into a corresponding a tuning code in response to analyzing the phase error metric, and output the tuning code to the tuning circuit 102.

To produce the tuning code from the phase error metric, the control circuitry 105 may analyze statistical properties of the phase error distribution, such as standard deviation, variance, or other relevant parameters. The control circuitry 105 may employ an algorithm to convert the phase error metric into a corresponding tuning code value. This algorithm may involve comparing the current phase error metric to predetermined thresholds or target values, and adjusting the tuning code accordingly to minimize phase misalignment between the I-clock and the Q-clock signals.

The tuning code may consist of a series of bits that control the operation of the tuning circuit 102, specifically managing the conductive and non-conductive states of in-phase switches S21(1) - S21(X) and quadrature-phase switches S22(1) - S22(X) in the in-phase LC circuit 201 and the quadrature-phase LC circuit 202.

Based on a phase error metric, the control circuitry 105 may dynamically adjust the operation of the tuning circuit 102. For instance, by manipulating the tuning code bits based on the phase error metric, the control circuitry 105 may precisely adjust the overall capacitance in each LC circuit 201, 202, thereby fine-tuning the phase relationship between the adjusted I-clock and the adjusted Q-clock signals. This process of deriving the phase error metric and producing the corresponding tuning code may enable the clock recovery system 100 to adaptively compensate for phase misalignment and optimize timing recovery under varying operating conditions.

The tuning circuit 102 may perform phase compensation. Phase compensation refers to the techniques and mechanisms employed by the tuning circuit 102 to correct for phase misalignment between the initial I-clock and the initial Q-clock. Phase compensation ensures that the adjusted I-clock and the adjusted Q-clock maintain a phase difference between one another as close as possible to the ideal 90 degrees.

To perform the phase compensation, the tuning circuit 102 may dynamically adjust the capacitance of in-phase capacitor bank C1 and quadrature-phase capacitor bank C2 based on the value of the tuning code. The tuning code may adjust the frequency of the initial I-clock and the initial Q-clock to align the phase relationship between the initial I-clock and the initial Q-clock to minimize any phase misalignment between the initial I-clock and the initial Q-clock. Clock phase alignment refers to the process of adjusting the relative timing between the initial I-clock and the initial Q-clock to achieve and maintain their intended phase relationship, typically a 90-degree offset. The tuning code may modify the relative timing of clock edges of the initial I-clock and the initial Q-clock to minimize timing skew by dynamically adjusting the relative timing of clock edges. Clock edge alignment refers to the process of adjusting the relative timing between clock edges to achieve a desired phase relationship, typically a 90-degree offset for the initial I-clock and the initial Q-clock.

The tuning code may comprise a series of bits that control the operation of the tuning circuit 102. Each bit in the tuning code may correspond to a specific switch in the LC circuits of the tuning circuit 102. For the in-phase LC circuit 201, bits in the tuning code may control the conductive and non-conductive states of the in-phase switches S21(1) - S21(X), which in turn may control the charging and/or discharging of the in-phase capacitors C21(1) - C21(X). Similarly, for the quadrature-phase LC circuit 202, bits in the tuning code may control the conductive and non-conductive states of the quadrature-phase switches S22(1) - S22(X), which in turn may control the charging and/or discharging of the quadrature-phase capacitors C22(1) - C22(X).

By manipulating bits in the tuning code, the control circuitry 105 may precisely adjust the overall capacitance in each of the LC circuits 201, 202, thereby fine-tuning the phase relationship between the adjusted I-clock and the adjusted Q-clock. This bit-level control of the tuning circuit 102 by the control circuitry 105 may allow for granular adjustments of the overall capacitance in each of the LC circuits 201, 202 to compensate for phase misalignment and timing skews between the adjusted I-clock and the adjusted Q-clock, ultimately enabling the clock recovery system 100 to maintain optimal timing alignment under varying conditions.

The tuning code may independently manage the conductive and non-conductive states of in-phase switches S21(1) - S21(X). A bit in the tuning code may correspond to an in-phase switch S21 in the LC circuit 201. The bit may control the charging and/or discharging of a specific capacitor C21 in the LC circuit 201. For instance, the bit may cause the opening and closure of in-phase switches S21. On such occasions, the bit may individually control an increase and/or decrease of the overall capacitance in the LC circuit 201. Being independently controllable, in-phase switches S21(1) - S21(X) may operate individually of one another. Upon closure of an in-phase switch S21, the in-phase switch S21 will become conductive and cause the passage of current between the 0 degree signal line and 180 degree signal line through a corresponding in-phase capacitor C21. More than one of the in-phase switches S21(1) - S21(X) may concurrently and/or simultaneously close. Upon opening of an in-phase switch S21, the in-phase switch S21 will become non-conductive and inhibit the passage of current between the 0 degree signal line and 180 degree signal line through a corresponding in-phase capacitor C21. More than one of the in-phase switches S21(1) - S21(X) may concurrently and/or simultaneously open.

A bit in the tuning code may correspond to a quadrature-phase switch S22 in the LC circuit 202. The bit may control the charging or discharging of a specific capacitor in the LC circuit 202. The bit may cause the opening and closure of quadrature-phase switches S22. The bit may individually control an increase or decrease of the overall capacitance in the LC circuit 202. Being independently controllable, quadrature-phase switches S22(1) - S22(X) may operate individually of one another. Upon closure of quadrature-phase switch S22, the quadrature-phase switch S22 will become conductive and cause the passage of current between the 90 degree signal line and 270 degree signal line through a corresponding quadrature-phase capacitor C22. More than one of the quadrature-phase switches S22(1) - S22(X) may concurrently and/or simultaneously close. Upon opening of quadrature-phase switch S22, the quadrature-phase switch S22 will become non-conductive and inhibit the passage of current between the 90 degree signal line and 270 degree signal line through a corresponding quadrature-phase capacitor C22. More than one of the quadrature-phase switches S22(1) - S22(X) may concurrently and/or simultaneously open.

The tuning circuit 102 may dynamically adjust the capacitances in the in-phase LC circuit 201 and the quadrature-phase LC circuit 202 to optimize the phase relationship between the adjusted I-clock and adjusted Q-clock signals. This dynamic adjustment process involves selectively activating or deactivating capacitors within the in-phase capacitor bank C1 and quadrature-phase capacitor bank C2 based on the tuning code generated by the control circuitry 105. By modifying the overall capacitance in each LC circuit, the tuning circuit 102 can introduce precise phase shifts to compensate for any misalignment between the I-clock and Q-clock signals.

For the in-phase LC circuit 201, the tuning code controls the conductive and non-conductive states of in-phase switches S21(1) - S21(X), which in turn affects the charging and discharging of in-phase capacitors C21(1) - C21(X). Similarly, for the quadrature-phase LC circuit 202, the tuning code manages the states of quadrature-phase switches S22(1) - S22(X) to adjust the capacitance of quadrature-phase capacitors C22(1) - C22(X). This fine-grained control allows the tuning circuit 102 to make subtle adjustments to the relative timing of clock edges, minimizing timing skew and ensuring that the phase difference between the adjusted I-clock and adjusted Q-clock remains as close as possible to the ideal 90 degrees.

The ability to dynamically adjust these capacitances enables the clock recovery system 100 to adapt to varying operating conditions, compensate for manufacturing variations, and maintain optimal timing alignment even in the presence of environmental factors such as temperature fluctuations or voltage variations. By providing precisely aligned clock phases to the phase interpolator 103, the tuning circuit 102 plays a crucial role in enabling accurate data sampling, improving jitter tolerance, and ultimately enhancing the overall bit error rate performance of the clock recovery system 100.

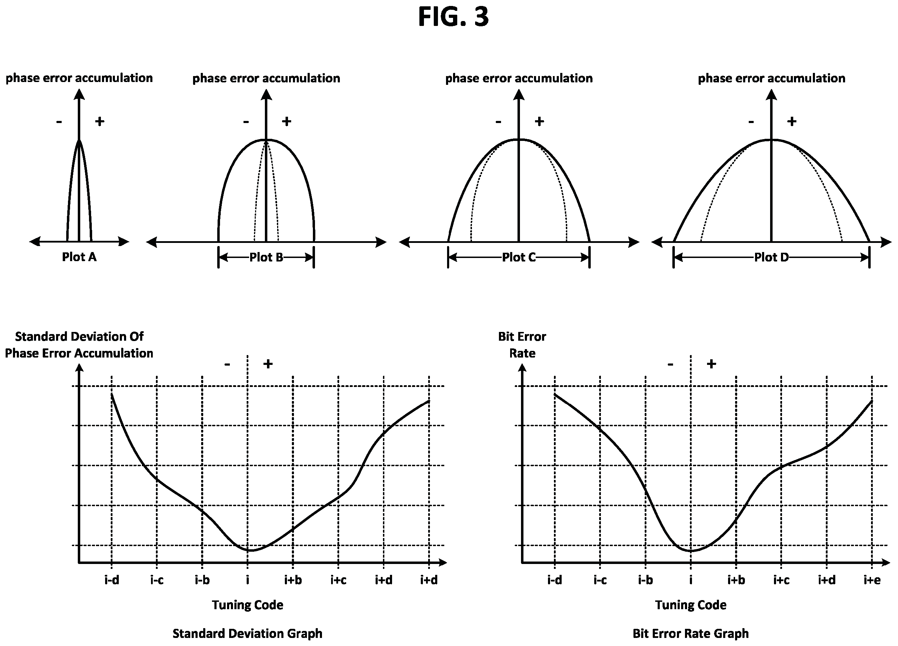

The phase error metric may include a standard deviation of the phase error, which may measure the spread or variability of phase error values around a mean, indicating overall stability of clock alignment. FIG. 3 illustrates four exemplary curves depicting plots A-D. The width of each curve is defined by the standard deviation, which is used to represent variability in phase error, jitter, or any normally distributed signal deviation.

The curve labeled as plot A represents a distribution of the phase error accumulation signal when the clock recovery system 100 is operating under optimal conditions with minimal jitter present. Jitter refers to short-term variations in the timing of signal transitions, which can degrade system performance. In this scenario, distribution of the phase error accumulation signal exhibits a narrow spread around the mean, indicating highly consistent and accurate timing alignment between the interpolated clock and the incoming analog waveform. This tight distribution suggests that the clock recovery system 100 is functioning efficiently, with minimal timing uncertainties or fluctuations. The narrow spread of plot A serves as a baseline for comparing performance under less ideal conditions, allowing engineers to quantify the impact of various factors on timing accuracy and overall system reliability.

Regarding plot A, the tuning code having a value of (i) may correspond to a tuning code having the minimum amount of deviation from the mean in the standard deviation graph at the lowest bit error rate as shown by the bit error rate graph. As used herein, the term "minimum amount" refers to the smallest value or quantity of a measured parameter that achieves a desired effect or performance threshold in the context of clock signal calibration. Specifically, it relates to the least deviation from an ideal phase relationship between adjusted clock signals that still results in optimal timing recovery and minimal bit error rates. The minimum amount is determined through iterative adjustment and measurement of phase error metrics, with the goal of finding the tuning code value that produces the smallest standard deviation in phase error accumulation signals. This minimum represents the point at which further adjustments in either direction would increase phase misalignment and degrade receiver performance.

The tuning code value (i) may result in the optimal phase alignment between the adjusted I-clock and the adjusted Q-clock signals from the tuning circuit 102. The standard deviation graph may represent the distribution of the phase error accumulation signal, with a smaller deviation signifying more consistent and accurate timing alignment between the interpolated clock and the incoming analog waveform. By minimizing this deviation, the clock recovery system 100 may achieve the most stable clock recovery performance. Concurrently, the lowest bit error rate as shown by the bit error rate graph may suggest that this tuning code value (i) enables the most accurate data sampling by the ADC 141, as fewer bits are misinterpreted due to phase misalignment.

This optimal tuning code value (i) may effectively compensate for any phase misalignment between the adjusted I-clock and the adjusted Q-clock, allowing the phase interpolator 103 to generate an interpolated clock that precisely aligns with the incoming data eye, thereby maximizing the ability of the clock recovery system 100 to accurately recover data from the incoming analog waveform.

The curve labeled as plot B represents a wider distribution of the phase error accumulation signal than in plot A. This wider distribution indicates a scenario where there is increased jitter or phase noise present in the clock recovery system 100. The wider spread of the phase error accumulation signal suggests that the timing alignment between the interpolated clock and the incoming analog waveform is less consistent and more variable compared to the optimal case represented by plot A. This increased variability may be due to factors such as frequency offset between transmitter and receiver clocks, degraded signal quality, or suboptimal tuning of the clock recovery system 100. The wider distribution in plot B implies that the ability the clock recovery system 100 to accurately sample the incoming data is compromised, potentially leading to higher bit error rates and reduced overall system performance. By analyzing the shape and width of this distribution, the control circuitry 105 can gain insights into the severity of phase misalignment and adjust the phase code and the tuning code accordingly to optimize the clock recovery process.

Regarding plot B, the tuning code having either a value of (i+b) or a value of (i-b) may correspond to the tuning code value that compensates for a wider distribution of the phase error accumulation signal than observed in plot A. This broader distribution indicates increased jitter or phase noise in the clock recovery system 100, resulting in less consistent timing alignment between the interpolated clock and the incoming analog waveform.

The tuning code value of (i-b) may adjust the capacitive loading through LC circuit 201 by controlling the switches S21(1) - S21(X). Similarly, the tuning code value of (i+b) may modify the capacitive loading through LC circuit 202, which comprises quadrature-phase inductor L2 and the quadrature-phase capacitor bank C2, by controlling the switches S22(1) - S22(X), also aiming to minimize the standard deviation of the phase error accumulation signal. This adjustment process continues until the standard deviation of the phase error accumulation signal reaches its minimum value. The minimum value of the standard deviation corresponds to a minimal bit error rate.

These adjustments to the capacitive loading effectively alter the phase relationship between the adjusted I-clock and the adjusted Q-clock. By doing so, the tuning circuit 102 may compensate for phase misalignment between the initial I-clock and the initial Q-clock, allowing for more precise alignment of the interpolated clock with the incoming analog waveform. This process of iterative adjustment and measurement enables the clock recovery system 100 to adapt to varying degrees of phase misalignment, ultimately improving the accuracy of data recovery and reducing bit error rates under less ideal operating conditions.

The curve labeled as plot C represents a wider distribution of the phase error accumulation signal than in plot B. This broader distribution indicates a scenario where there is increased jitter or phase noise present in the clock recovery system 100. The wider spread of phase error values suggests that the timing alignment between the interpolated clock and the incoming analog waveform is less consistent and more variable compared to the case represented by plot B. This increased variability may be due to factors such as a larger frequency offset between the transmitter and receiver clocks, further degraded signal quality, or suboptimal tuning of the clock recovery system 100. The wider distribution in plot C implies that the ability to accurately sample the incoming data is more severely compromised, potentially leading to even higher bit error rates and further reduced overall system performance compared to the situation depicted in plot B. By analyzing the shape and width of this distribution, the control circuitry 105 can gain insights into the severity of phase misalignment and adjust the tuning code accordingly to optimize the clock recovery process under these more challenging conditions.

Regarding plot C, the tuning code having either a value of (i+c) or a value of (i-c) may correspond to the tuning code value that compensates for a wider distribution of the phase error accumulation signal than observed in plot B. This broader distribution indicates an even more severe scenario of jitter or phase noise present in the clock recovery system 100 compared to plot B. The wider spread of phase error values suggests that the timing alignment between the interpolated clock and the incoming analog waveform is significantly less consistent and more variable than in the case represented by plot B.

This increased variability may be due to factors such as a larger frequency offset between the transmitter and receiver clocks, further degraded signal quality, or suboptimal tuning of the clock recovery system 100. The wider distribution in plot C implies that the ability of the clock recovery system 100 to accurately sample the incoming data is more severely compromised, potentially leading to even higher bit error rates and further reduced overall system performance compared to the situation depicted in plot B.

The tuning code values (i+c) and (i-c) represent more aggressive adjustments to the capacitive loading through the LC circuits 201 and 202. These adjustments aim to compensate for the increased phase misalignment and timing skew introduced by the more severe jitter or phase noise. The tuning code value of (i-c) may adjust the capacitive loading through LC circuit 201 by controlling the switches S21(1) - S21(X). Similarly, the tuning code value of (i+c) may modify the capacitive loading through LC circuit 202, which comprises quadrature-phase inductor L2 and the quadrature-phase capacitor bank C2, by controlling the switches S22(1) - S22(X), also aiming to minimize the standard deviation of the phase error accumulation signal.

This adjustment process continues until the standard deviation of the phase error accumulation signal reaches its minimum value. The minimum value of the standard deviation corresponds to a minimal bit error rate. By applying these tuning code values to the tuning circuit 102, the control circuitry 105 may attempt to bring the clock recovery system 100 back towards a more stable operating state, minimizing the standard deviation of the phase error accumulation signal.

By analyzing the shape and width of this distribution, the control circuitry 105 can gain insights into the severity of phase misalignment and adjust the tuning code accordingly to optimize the clock recovery process under these more challenging conditions. The phase error metric derived from this wider distribution would likely trigger more aggressive corrective actions by the control circuitry 105 to improve the timing alignment between the interpolated clock and the incoming analog waveform.

The curve labeled as plot D represents the widest distribution of the phase error accumulation signal among all the plots shown. This broadest distribution indicates a scenario where there is the most severe jitter or phase noise present in t the clock recovery system 100. The extremely wide spread of phase error values suggests that the timing alignment between the interpolated clock and the incoming analog waveform is highly inconsistent and variable compared to the cases represented by plots A, B, and C. This increased variability may be due to factors such as a significantly larger frequency offset between transmitter and receiver clocks, severely degraded signal quality, or grossly suboptimal tuning of the clock recovery system 100. The wider distribution in plot D implies that the ability of the clock recovery system 100 to accurately sample the incoming data is critically compromised, potentially leading to substantially higher bit error rates and severely reduced overall system performance compared to the situations depicted in plots A, B, and C. By analyzing the shape and width of this distribution, the control circuitry 105 can gain insights into the extreme severity of phase misalignment and adjust the tuning code accordingly to optimize the clock recovery process under these most challenging conditions. The phase error metric derived from this widest distribution would likely trigger more aggressive corrective actions by the control circuitry 105 to bring the clock recovery system 100 back into a more stable operating state.

Regarding plot D, the tuning code having either a value of (i+d) or a value of (i-d) may correspond to the tuning code value that compensates for a wider distribution of the phase error accumulation signal than observed in plot C. This broader distribution indicates a scenario where there is even more severe jitter or phase noise present in the clock recovery system 100 compared to plot C. The extremely wide spread of phase error values suggests that the timing alignment between the interpolated clock and the incoming analog waveform is highly inconsistent and variable. This increased variability may be due to factors such as a significantly larger frequency offset between the transmitter and receiver clocks, severely degraded signal quality, or grossly suboptimal tuning of the clock recovery system 100.

The tuning code values of (i+d) and (i-d) represent more aggressive adjustments to the capacitive loading through the LC circuits 201 and 202. These adjustments aim to compensate for the extreme phase misalignment observed in this scenario. By modifying the capacitance in the in-phase and quadrature-phase LC circuits 201, 202, the tuning circuit 102 may bring the phase relationship between the adjusted I-clock and the adjusted Q-clock closer to the ideal 90-degree offset, even under these challenging conditions.

The control circuitry 105 may need to employ more sophisticated algorithms or wider search ranges to find the optimal tuning code values in this case. The phase error metric derived from this widest distribution would likely trigger more aggressive corrective actions to bring the clock recovery system 100 back into a more stable operating state. This may involve larger step sizes in the tuning code adjustments or more iterations of the optimization process to converge on a solution that minimizes the phase error metric.

The wider distribution in plot D implies that the receiver's ability to accurately sample the incoming data is critically compromised, potentially leading to substantially higher bit error rates and severely reduced overall system performance compared to the situations depicted in plots A, B, and C.

The control circuitry 105 can gain insights into the extreme severity of phase misalignment and adjust the tuning code accordingly to optimize the clock recovery process under these most challenging conditions by analyzing the shape and width of this distribution of the phase error accumulation signal. By providing precisely aligned phases of the adjusted I-clock and the adjusted Q-clock to the phase interpolator 103, the tuning circuit 102 may enable more accurate data sampling, improved jitter tolerance, and ultimately, better bit error rate performance in the clock recovery system 100.

The control circuitry 105 may dynamically adjust the operation of the phase interpolator 103 based on another performance metric to maintain optimal timing recovery under varying conditions. In such cases, the performance metric may happen to be the feedback signal from the loop filter 144. The control circuitry 105 may dynamically adjust the phase code based on the feedback signal. The phase interpolator 103 may maintain interpolation resolution across various operating conditions through adaptive calibration mechanisms that compensate for temperature and voltage variations.

The phase code is a digital control word that specifies the phase of the adjusted I-clock and the adjusted Q-clock, representing a fractional phase position between two or more phases of the adjusted I-clock and the adjusted Q-clock. Dynamically adjusting the phase code refers to the continuous process of modifying the phase code in real-time to compensate for timing variations in the incoming analog waveform.

Dynamically adjusting the phase code may refer to the continuous process of modifying a digital control word (the phase code) that specifies the phase relationship between the adjusted I-clock and the adjusted Q-clock in real-time. This adjustment may allow the clock recovery system 100 to adapt to timing variations in the incoming analog waveform. The control circuitry 105 may monitor the feedback signal from the loop filter 144 to determine whether the interpolated clock is early or late relative to the optimal sampling points of the incoming analog waveform. Based on this information, the control circuitry 105 may incrementally adjust the phase code, typically by incrementing or decrementing the phase code value. These fine-tuned adjustments may enable the phase interpolator 103 to maintain precise alignment between the interpolated clock and the incoming data eye, compensating for factors such as jitter, frequency offset, and environmental variations. By continuously optimizing the phase code, the clock recovery system 100 may ensure consistent and accurate sampling of the incoming analog waveform across varying operating conditions, ultimately minimizing bit error rates and improving overall receiver performance.

The control circuitry 105 may monitor the feedback signal to dynamically adjust the phase code. By dynamically adjusting the phase code, the control circuitry 105 may allow the clock recovery system 100 to track changes in the data timing of the incoming analog waveform. This adaptive phase tracking compensates for factors such as jitter, frequency offset, and/or environmental variations, ensuring consistent and accurate sampling of the incoming analog waveform.

Based on the feedback signal from the loop filter 144, the control circuitry 105 may produce the phase code to maintain optimal alignment between the interpolated clock and incoming analog waveform. In some instances, producing the phase code may include generating the phase code. Other instances, producing the phase code may include modifying the phase code.

The phase code may include multiple bits that encode the desired phase position as a fraction of the full clock period. By incrementing and/or decrementing the phase code based on whether the interpolated clock is early or late relative to data timing in the incoming analog waveform, the control circuitry 105 may control the phase interpolator 103 to maintain optimal phase alignment with the data eye of the incoming analog waveform. The control circuitry 105 may output the phase code to the phase interpolator 103.

The phase interpolator 103 may perform phase interpolation by blending the adjusted I-clock and the adjusted Q-clock from the tuning circuit 102 to produce an interpolated clock of an intermediate phase. The phase interpolator 103 may receive the phase code, as illustrated in the example of FIG. 1. The phase code may be a discrete value that the phase interpolator 103 processes to determine the intermediate phase between two or more phases of the adjusted I-clock and the adjusted Q-clock. The phase interpolator 103 can produce a continuous range of fractional phase positions between two or more clock phases of the adjusted I-clock and the adjusted Q-clock, enabling precise alignment of the interpolated clock with the incoming analog waveform signal.

The phase code is of a value that represents the fractional phase position between two or more clock phases of the adjusted I-clock and the adjusted Q-clock. The phase interpolator 103 may translate the phase code into analog weighting factors that precisely defines the fractional phase position. The phase code defines the amount of the phase shift between the adjusted I-clock and the adjusted Q-clock. By creating an intermediate phase between phases of the adjusted I-clock and the adjusted Q-clock, the phase interpolator 103 may generate the interpolated clock with a programmable phase shift between the adjusted I-clock and the adjusted Q-clock. The phase interpolator 103 may reduce bit error rates by enabling the ADC 141 to sample the incoming analog waveform at optimal timing points.

The arrangement or interconnection of components, as indicated by terms such as "coupled," "connected," "on," or "under," may allow for indirect connections or the presence of intervening components or layers. In contrast, terms such as "electrically connected directly," "electrically directly connected," and "directly electrically connected" refer specifically to connections along a conductive path without any intermediary component.

Certain operations of methods described in this technology, or systems executing those methods, may be schematically represented in figures or textual descriptions. Unless explicitly stated, the spatial arrangement of operations in figures does not necessarily dictate the sequence in which they must be performed. Operations may be executed in a different order than illustrated, depending on implementation requirements. Additionally, certain operations may be performed in parallel or partially in parallel, utilizing dedicated parallel processing devices or separate computing systems that interoperate within a larger system.

The term "or," unless otherwise defined or limited, denotes a non-exclusive list, allowing various combinations of listed elements rather than restricting them to mutually exclusive alternatives. For example, a list including "A, B, or C" may encompass A alone, B alone, C alone, any combination of two elements, or all three elements together. Exclusivity applies only when expressly stated using terms such as "either," "only one of," or "exactly one of." Similarly, lists preceded by phrases such as "one or more of" or "at least one of" indicate the possibility of multiple occurrences of any or all listed elements. A list introduced by "a plurality of" or "two or more of" suggests multiple instances of any or all elements. The term "or" should only be interpreted as exclusive when explicitly specified by contextual qualifiers.

The articles "a," "an," and "the" generally encompass both singular and plural forms unless explicitly stated otherwise. The terms "comprises," "includes," and "has" indicate the presence of stated features, components, operations, or elements while not excluding additional features, components, or combinations thereof.

Throughout this document, ordinal numbers such as "first," "second," and "third" may be used to describe various elements. These terms serve solely to distinguish elements from one another rather than imply a specific sequence, hierarchy, or limitation on quantity. Ordinal numbers do not necessarily dictate an order unless explicitly modified by terms such as "before," "after," or "single." A first element is distinct from a second element, and the first element may contain multiple components or appear before or after the second element in a given arrangement. The designation of ordinal numbers may be interchangeable without altering the scope of the described examples.

Any trademarks referenced herein may be common law or registered trademarks of third parties affiliated or unaffiliated with the applicant or assignee. These references are provided for illustrative purposes only and should not be interpreted as limiting the disclosed embodiments to material associated exclusively with those trademarks.

## Claims

1. An apparatus, comprising:
control circuitry configured to:
derive, from a signal, a phase error metric, and
produce, from the phase error metric, a tuning code; and
a tuning circuit configured to:
receive, from a multiphase clock generator, an I-clock and a Q-clock, and
reduce, in accordance with the tuning code, phase misalignment between the I-clock and the Q-clock.

2. The apparatus of claim 1, further comprising:
a phase interpolator configured to:
interpolate, in response to the tuning circuit reducing the phase misalignment between the I-clock and the Q-clock, the I-clock and the Q-clock to produce an interpolated clock.

3. The apparatus of claim 2, wherein
a phase of the interpolated clock is between a phase of the I-clock and a phase of the Q-clock.

4. The apparatus of any one of the claims 1 to 3, further comprising:
sampling circuitry configured to:
sample, using the interpolated clock, an incoming analog waveform.

5. The apparatus of claim 4, wherein
the sampling circuitry is configured to produce, in response to sampling the incoming analog waveform, the signal.

6. The apparatus of claim 4 or 5, wherein
the control circuitry is configured to dynamically adjust, based on another signal from the sampling circuitry, a phase code;
wherein in particular
the phase interpolator is configured to interpolate, in accordance with the phase code, the I-clock and the Q-clock.

7. The apparatus of any one of the claims 1 to 6, wherein
the I-clock comprises a clock phase at 0° and a clock phase at 180°.

8. The apparatus of any one of the claims 1 to 7, wherein
the tuning circuit is configured to adjust, to reduce the phase misalignment between
the I-clock and the Q-clock, a phase of the I-clock.

9. The apparatus of claim 8, wherein
the tuning circuit comprises an in-phase LC circuit configured to adjust, in accordance with the tuning code, the phase of the I-clock;
wherein in particular
the in-phase LC circuit comprises an I-capacitor bank.
wherein further in particular
the control circuitry is configured to adjust, based on the tuning code, capacitance of the I-capacitor bank.

10. The apparatus of any one of the claims 1 to 9, wherein
the Q-clock comprises a clock phase at 90° and a clock phase at 270°.

11. The apparatus of any one of the claims 1 to 10, wherein
the tuning circuit is configured to adjust, to reduce the phase misalignment between
the I-clock and the Q-clock, a phase of the Q-clock.

12. The apparatus of claim 11, wherein
the tuning circuit comprises a quadrature-phase LC circuit configured to adjust, in accordance with the tuning code, the phase of the Q-clock;
wherein in particular
the quadrature-phase LC circuit comprises a Q-capacitor bank;
wherein further in particular
the control circuitry is configured to adjust, based on the tuning code, capacitance of the Q-capacitor bank.

13. A system comprising:
the apparatus of any one of the claims 1 to 12; and
the multiphase clock generator,
wherein the multiphase clock generator is configured to generate the I-clock and the Q-clock.

14. A method, comprising:
receiving, by a tuning circuit from a multiphase clock generator, an I-clock and a Q-clock;
deriving, by control circuitry from a signal, a phase error metric;
producing, by the control circuitry from the phase error metric, a tuning code; and
reducing, by the tuning circuit in accordance with the tuning code, phase misalignment between the I-clock and the Q-clock.

15. The method of claim 14, further comprising:
interpolating, by a phase interpolator in response to the tuning circuit reducing the phase misalignment between the I-clock and the Q-clock, the I-clock and the Q-clock to produce an interpolated clock.
